# EUROPÄISCHE PATENTSCHRIFT

(11) **EP 0 797 379 B1**
(45) Veröffentlichungstag und Bekanntmachung des Hinweises auf die Patenterteilung: **18.09.2002**
(21) Anmeldenummer: 97101240.6
(22) Anmeldetag: 28.01.1997
(51) Int. Cl.: H05K 1/18, H01T 4/06, H05K 5/02

(54) **Leiterplatte und Verfahren zum lagegegenauen Bestücken und Löten von elektronischen Bauelementen auf der Oberfläche der Leiterplatte**
Circuit board and process for mounting and soldering of electronic components in accurate positions on the surface of the circuit board
Panneau à circuit et procédé de montage et de soudage de composants électroniques en positions précises sur la surface du panneau à circuit

(30) Priorität: 18.03.1996 DE 19610586; 25.03.1996 DE 19611631; 21.05.1996 DE 19620340
(43) Veröffentlichungstag der Anmeldung: 24.09.1997
(73) Patentinhaber: KRONE GmbH, 14167 Berlin (DE)
(72) Erfinder: Busse, Ralf-Dieter, Dipl.-Ing., 12679 Berlin (DE); Storbeck, Carsten, Dipl.-Ing., 14109 Berlin (DE); Lade, Thomas, Dipl.-Ing., 12105 Berlin (DE)

(56) Entgegenhaltungen:
- EP-A- 0 111 222
- WO-A-90/13990
- DE-A- 2 032 994
- DE-A- 3 501 710
- DE-B- 1 071 170
- GB-A- 820 824
- GB-A- 2 204 184
- PATENT ABSTRACTS OF JAPAN vol. 16, no. 462 (E-1269), 25.September 1992 & JP 04 163987 A (NEC CORP), 9.Juni 1992,
- PATENT ABSTRACTS OF JAPAN vol. 14, no. 528 (E-1004), 20.November 1990 & JP 02 224293 A (TOSHIBA CORP), 6.September 1990,
- PATENT ABSTRACTS OF JAPAN vol. 14, no. 145 (E-0905), 19.März 1990 & JP 02 009193 A (NEC CORP), 12.Januar 1990,

## Beschreibung

Die Erfindung betrifft eine Leiterplatte zum lagegenauen Bestücken derselben mit elektronischen Bauelementen auf der Oberfläche der Leiterplatte. Insbesondere soll die erfindungsgemäß ausgebildete Leiterplatte für den Einsatz in Überspannungsschutz-Baugruppen eingesetzt werden, wobei als elektronische Bauelemente Überspannungsleiter, PTCs, Varistoren und Dioden eingesetzt werden sollen.

Es ist bekannt, die Überspannungsleiter durch ein Reflow-Lötverfahren auf der Leiterplatte aufzubringen und die anderen elektronischen Bauteile, wie PTCs, Varistoren und Dioden als Chipbauelemente, mit Hilfe der herkömmlichen Klemmtechnik zu kontaktieren. Dabei treten Probleme bei der lagegenauen Ausrichtung des Überspannungsleiters auf, wenn dieser bei der Bestückung bzw. während des Lötvorganges nicht in der gewünschten Position gehalten wird und es so gegebenenfalls zu Kontaktproblemen kommen kann oder bei der weiteren Bearbeitung oder Montage der Leiterplatte Schwierigkeiten auftreten können.

Durch die unterschiedlichen Verfahren, mit denen die verschiedenen Bauelemente auf die Leiterplatte gebracht werden, sind zur Kontaktierung mehrere Arbeitsgänge erforderlich. Außerdem sind zusätzliche Kontaktbleche für die Bestückung der Leiterplatte mit den anderen Bauelementen (PTCs und Varistoren) erforderlich, die den Material- und Fertigungsaufwand ebenfalls erhöhen.

Beim Reflow-Löten ist es üblich, auf den Leiterplatten an Stellen, die ein Elektronikbauteil aufnehmen sollen, entsprechend Lotmaterial aufzutragen. Im Anschluss daran wird auf das noch im pastösen Zustand befindliche Lot das jeweilige Bauteil aufgesetzt und im Anschluss daran die vollständig bestückte Leiterplatte erwärmt, bis das Lot schmilzt und nach Abkühlung durch das wiedererstarrte Lotmaterial auf der Leiterplatte festgehalten wird und elektrisch kontaktiert wird.

Solange das Lotmaterial noch keine innige Verbindung des elektronischen Bauteils mit der Leiterplatte, also direkt nach dem Aufsetzen der Bauteile, bewirkt, kann das jeweilige elektronische Bauteil verrutschen und so die gewünschte Position werden. Da das Reflow-Lötverfahren in der Regel in Durchlauföfen, wie sie beispielsweise aus der DE 40 16 366 C2 bekannt sind, durchgeführt wird, müssen insbesondere beim Transport der vorab bestückten Leiterplatte Vorkehrungen getroffen werden, die verhindern, dass durch die Bewegung bzw. Erschütterungen ein Verrutschen der Bauelemente aus der gewünschten Position erfolgt.

Um ein solches Verrutschen zu verhindern, ist beispielsweise aus der EP 0 540 497 A2 das Verwenden einer Matrize bekannt, die jedoch lediglich die Oberflächenform des Lotes, das auf Lötpunkte aufgebracht wird,. vorgeben kann. Eine Fixierung des Bauteiles zumindest in einem gewissen Maß ist jedoch mit dieser Lösung nicht möglich. Das Positionieren soll dadurch erleichtert werden, dass die erzeugten Lötstellen eine ebene Oberfläche aulweisen.

Die Verwendung eines Klebstoffes, mit dem Bauelemente auf einer Leiterplatte befestigt werden sollen, geht aus der DE 41 26 913 A1 hervor. Hierbei wird die Verbindung des jeweiligen Bauelementes mit einem Klebstoff auf der Leiterplatte hergestellt. Im Anschluss daran wird der eigentliche Lötvorgang durchgeführt und die vollständige Verbindung letztendlich hergestellt. Neben dem zusätzlich erforderlichen Klebstoff, dessen Zuführung einen entsprechenden erhöhten Aufwand bei der Leiterplattenbestückung erfordert, sind hohe Anforderungen an den zu verwendenden Klebstoff zu stellen. Da dieser während des Lötvorganges einem erhöhten Temperatureinfluss ausgesetzt wird, kann es zu Gefährdungen durch eventuell im Klebstoff verwendete Lösungsmittel kommen.

Aus dem Patent Abstracts of Japan vol. 14, no. 528 (E-1004), 20. November 1990 & JP 02 22 42 93 A ist eine Leiterplatte zur lagegenauen Bestückung mit elektronischen Bauelementen bekannt, wobei in der Oberfläche der Leiterplatte der Außenkontur der jeweiligen Bauelemente angepasste Bereiche zur Aufnahme der elektronischen Bauelemente eingearbeitet sind, wobei die Innenflächen der angepassten Bereiche teilweise randmetallisiert sind.

Aus der GB-2 204 184 A ist eine Leiterplatte zur lagegenauen Bestückung mit elektronischen Bauelementen bekannt, wobei die elektronischen Bauelemente auf der Oberfläche der Leiterplatte angelötet werden, wobei in der Oberfläche der Leiterplatte der Außenkontur der jeweiligen Bauelemente angepasste Bereiche zur Aufnahme der elektronischen Bauelemente eingearbeitet sind, wobei die Innenflächen der angepassten Bereiche teilweise randmetallisiert und die eingearbeiteten Bereiche als Schlitze ausgebildet sind.

Aus der EP 0 111 222 A1 ist eine Leiterplatte bekannt, auf deren Oberfläche elektronische Bauelemente angelötet werden, wobei in die Leiterplatte der Außenkontur der jeweiligen Bauelemente angepasste Bereiche zur Aufnahme der elektronischen Bauelemente eingearbeitet sind, wobei die eingearbeiteten Bereiche durch die gesamte Tiefe der Leiterplatte gehen.

Der Erfindung liegt das technische Problem zugrunde, eine Leiterplatte zur lagegenauen Bestückung mit elektronischen Bauelementen zu schaffen, die sicherer zu handhaben ist.

Die Lösung des technischen Problems ergibt sich durch den Gegenstand mit den Merkmalen des Patentanspruchs 1. Weitere vorteilhafte Ausgestaltungen der Erfindung ergeben sich aus den Unteransprüchen.

Hierzu sind die eingearbeiteten Bereiche als Schlitzkontur ausgebildet und die Innenflächen der eingearbeiteten Bereiche an den Längsflächen randmetallisiert, wobei auf der Unterseite der Leiterplatte eine isolierende Abdeckung aufgebracht ist. Die isolierende Abdeckung kann als Folie oder durch mittels eines Dispensverfahrens aufgebrachten Isolators realisiert werden, die einen ausreichenden Berührungsschutz der gesamten Baugruppe von der Unterseite ermöglicht.

Durch die in die Oberfläche der Leiterplatte eingearbeiteten Bereiche, in die die elektronischen Bauelemente eingesetzt werden, ist es durch die versenkte Anordnung möglich, die gesamte erforderliche Bauhöhe zu reduzieren oder bei Verwendung von dickeren Leiterplatten eine Vergrößerung der erforderlichen Bauhöhe zu vermeiden. Die Verwendung von in ihrer gesamten Höhe größeren Leiterplatten wirkt sich auch durch die höhere Wärmebelastbarkeit während des Lötprozesses positiv aus. Werden beispielsweise die erfindungsgemäß ausgebildeten Leiterplatten mit Überspannungsableitern bestückt, bestimmen diese im wesentlichen die insgesamt erforderlichen Bauhöhen, die nicht erhöht oder gar verringert werden kann. Es sind Anschlußleisten bzw. Trennleisten mit zwei Reihen von Schneidklemmkontakten bekannt. An den Schneidklemmkontakten sind Kabeladern angeschlossen. Wird die bestückte Leiterplatte als Schutzstecker verwendet und in eine Trennleiste eingesteckt, so sind die mindestens zwei Schneidklemmkontakte der ersten Reihe durch den Schutzstecker abgedeckt. Aufgrund der geringen Bauhöhe des Schutzsteckers ist gewährleistet, dass die zweite Reihe von Schneidklemmkontakten bei gestecktem Schutzstecker frei zugänglich und beschaltbar ist. Anstelle der Leiterplatte kann es sich auch um eine einfachere Grundplatte handeln, die bestückt aber auch mit einem Gehäuse abgedeckt werden kann.

Die zur Aufnahme der jeweiligen Bauelemente ausgebildeten, in die Leiterplatte eingearbeiteten Bereiche sind so dimensioniert, dass die Tiefe der Leiterplatte weitestgehend ausnutzbar und dadurch eine möglichst große Lötfläche erreichbar ist.

Zur Erhöhung der Benetzungsfähigkeit der Bauelemente sind die Schlitzkonturen ausgebildeten Bereiche zumindest teilweise randmetallisiert. Dabei ist der metallisierte Teil der für die Aufnahme der Bauelemente ausgebildeten Bereiche an den Längsflächen metallisiert ausgebildet. Das Metallisieren kann, wie dies beispielsweise für durchkontaktierte Bohrungen bekannt ist, durch galvanisches Aufmetallisieren erfolgen.

Vor der eigentlichen Bestückung der Leiterplatte mit den elektronischen Bauelementen wird die zu verwendende Lötpaste für alle Bauelemente bevorzugt in einem Arbeitsgang entweder mittels Schablonendruck oder in Form eines Dispensverfahrens aufgebracht. Dadurch kann erreicht werden, dass nur die Bereiche, die unbedingt für die Herstellung der Verbindung erforderlich sind, mit Lötpaste versehen werden und dadurch trotz einer sicheren Herstellung der geforderten Verbindung zwischen Leiterplatte und Bauelementen keine zusätzliche Nachbearbeitung erforderlich wird.

In einer weiteren bevorzugten Ausführungsform ist mindestens ein eingearbeiteter Bereich in Form einer Nut ausgebildet.

In einer weiteren bevorzugten Ausführungsform sind neben den eingearbeiteten Bereichen Anschlüsse oder Anschlussflächen, vorzugsweise an den Rändern, angeordnet.

Die erfindungsgemäße Leiterplatte kann mit einem Gehäuse abgedeckt werden und mit elektronischen Bauelementen als Überspannungsschutz-Modul bestückt sein. Dabei sind am Gehäuse mehrere, jedoch mindestens zwei domartig ausgebildete Ansätze aus einem zumindest teilweise verformbaren Material angeordnet. Diese Ansätze ragen am Gehäuse in Richtung auf die zu verbindende Leiter- bzw. Grundplatte und greifen in dort eingearbeitete Ausnehmungen ein. Die Größe der domartig ausgebildeten Ansätze ist dabei so, dass sie während der Montage problemlos in die Ausnehmungen geführt werden können und unter Einwirkung einer Energie und/oder Kraft so verformt werden, dass eine form- und/oder kraftschlüssige Verbindung zwischen Gehäuse und Leiterplatte entsteht. Die Ansätze sind dabei weiter so zu dimensionieren, dass sie nach der durch Energie- und/oder Krafteinfluss erreichten Verformung nicht über die Ebene, die durch die Unterseite der Platte vorgegeben ist, hervorstehen und dadurch gewährleisten, dass die für solche Module geforderte Beschaltbarkeit gegeben ist.

Durch die erfindungsgemäße Ausbildung kann weiter vorteilhaft gesichert werden, dass die Module problemlos unter Verringerung des erforderlichen Raumes als Schutzstecker steckbar sind, ohne dass es zu Beeinträchtigungen zwischen nebeneinander angeordneten Modulen oder anderen Schaltungselementen kommt.

Die Herstellung kann dabei vorteilhaft in einem Automaten mit zwei Arbeitsgängen durchgeführt werden, wobei einmal das Gehäuse auf bzw. in die Leiterplatte eingesetzt und dort gehalten wird und im zweiten Schritt die Verformung der Ansätze aktiviert wird. Dies kann vorteilhaft durch Druck mit beheizten Dornen gegen die Stirnflächen der domartig ausgebildeten Ansätze erreicht werden. Die Erwärmung bewirkt ein Erweichen des Ansatzmaterials und durch den Druck der Dorne kann die gewünschte Form erzeugt werden, die sichert, dass die Leiter- bzw. Grundplatte und das Gehäuse spielfrei miteinander verbunden werden.

Die Erwärmung der Dorne kann beispielsweise durch Widerstandsbeheizung durchgeführt werden. Es besteht aber auch die Möglichkeit, andere Energieformen, beispielsweise unter Verwendung beliebiger elektromagnetischer Strahlung auszunutzen, um eine Temperaturerhöhung und damit ein Erweichen des Ansatzmaterials, einen geeigneten Kunststoff, vorzugsweise ein thermoplastisches Material, zu ermöglichen.

In einer weiteren bevorzugten Ausführungsform sind die Ausnehmungen als Sackloch und/oder als verjüngende Senke und/oder als gleichförmig ausgebildete Bohrungen oder mit einem eckigen Querschnitt ausgebildete Durchbrechungen ausgebildet.

In einer weiteren bevorzugten Ausführungsform weisen die Ansätze an ihrer Richtung auf die Unterseite der Leiterplatte weisenden Stirnfläche eine Vertiefung oder Einkerbung auf.

Mit entsprechender Bestückung kann ein Überspannungs-Schutzstecker, der die beiden Funktionen "Erdkontakt" und "Fail-Safe-Kontakt" in einem Teil, das durch Stanzen und im Anschluss daran durch Biegen entsprechend ausgebildet werden kann, vereinigt hergestellt werden. Diese Ausführung hat den Vorteil, dass der Montageaufwand wesentlich verringert wird und für das Einsetzen in das Gehäuse nur noch lineare Fügebewegungen, die für den Einsatz von Montageautomaten besonders günstig sind, durchgeführt werden müssen.

Ein weiterer Vorteil besteht darin, dass die Anzahl der Übergangsstellen, die mit Stoßstrom belastet werden, reduziert werden kann.

Der zweite Kontaktbügel hat im montierten Zustand eine ständige Vorspannkraft gegen die an dem Überspannungsableiter vorhandenen Außenelektroden. Während des normalen Betriebszustandes wird das Thermoelement gegen die Vorspannkraft des zweiten Kontaktbügels oder isoliert den zweiten Kontaktbügel gegenüber den Außenelektroden und verhindert damit, dass eine elektrisch leitende Verbindung zwischen dem Kontaktelement und den Außenelektroden des Überspannungsableiters vorhanden ist. Das Thermoelement kann als am zweiten Kontaktbügel befestigte Lotpille ausgebildet sein oder in eine entsprechend in den Kontaktbügel eingearbeitete Ausnehmung einrasten. Bei dieser letztgenannten Lösung wird das Kontaktelement zunächst ohne das Thermoelement im Gehäuse des Schutzsteckers fixiert. Nach der Verbindung des Gehäuses mit der Leiterplatte des Schutzsteckers wird das Thermoelement nachträglich im zweiten Kontaktbügel eingerastet und der Fail-Safe-Kontakt vollständig vorgespannt und funktionsfähig gemacht.

Das Thermoelement kann als Formteil aus einem Material beispielsweise einem Metall bestehen, das bei Erwärmung schmilzt und so die Bewegung des zweiten Kontaktbügels in Richtung auf die Außenelektrode des Überspannungsleiters freigibt, so dass eine leitende Verbindung zwischen den Femmeldeadern und der Erdschiene hergestellt wird. Das Material wird mit seiner Schmelztemperatur so ausgewählt, dass Beschädigungen der Anlage oder gar eine Brandgefahr ausgeschlossen werden können.

Das Thermoelement kann aber auch aus einem Material bestehen, das bei einer entsprechenden Erwärmung des Überspannungsableiters lediglich erweicht und so unter der Vorspannkraft des zweiten Kontaktbügels nachgibt, dass dieser mit den Außenelektroden in Kontakt treten und die leitende Verbindung zu diesen herstellen kann.

Weitere Möglichkeiten bestehen in der Verwendung von Bimetallen oder bekannter Memorylegierungen, die in der Lage sind, bei Erwärmung den zweiten Kontaktbügel des Kontaktelementes für die Verbindung mit den Außenelektroden des Überspannungsableiters freizugeben.

Auch kann das Thermoelement aus einem isolierenden Lack oder einer isolierenden Folie bestehen, die zwischen den Außenelektroden des Überspannungsableiters und dem federnd an diesen anliegenden zweiten Kontaktbügel angeordnet ist und diese elektrisch gegeneinander isoliert. Der Lack bzw. die Folie schmilzt bei Erwärmung, wodurch die leitende Verbindung hergestellt wird.

In einer weiteren bevorzugten Ausführungsform ist das Thermoelement fest mit dem zweiten Kontaktbügel verbunden, wobei weiter vorzugsweise das Thermoelement in den zweiten Kontaktbügel eingerastet ist.

Am Kontaktelement ist bevorzugt mindestens ein als Widerlager dienendes Haltebein auf der dem ersten Haltebügel gegenüberliegenden Seite des Überspannungsableiters an dessen isolierender Oberfläche federnd anliegend ausgebildet. Hierdurch wird eine einseitige Belastung der Lötverbindung zwischen dem Überspannungsableiter und der diesen tragenden Leiterplatte vermieden.

Nachfolgend soll die Erfindung anhand von Ausführungsbeispielen näher beschrieben werden. Dabei zeigen:
- Fig. 1: eine erfindungsgemäß ausgebildete Leiterplatte vor der Bestückung,
- Fig. 2: eine mit Bauelementen bestückte Leiterplatte nach Fig. 1,
- Fig. 3: eine bestückte Leiterplatte mit bereits aufgesetztem Gehäuse vor der letztendlichen Verbindung,
- Fig. 4: eine schematische Darstellung eines domartig ausgebildeten Ansatzes am Gehäuse,
- Fig. 5: mehrere Ausführungsformen für in der Leiterplatte zu verwendenden Ausnehmungen,
- Fig. 6: ein Beispiel eines Kontaktelementes für einen Überspannungs-Schutzstecker,
- Fig. 7: das auf einen Überspannungsableiter aufgesetzte Kontaktelement nach Fig. 6,
- Fig. 8: einen Schutzstecker für die Verwendung in Telekommunikationsanlagen unter Einsatz des Kontaktelementes nach Fig. 6 und
- Fig. 9: ein zweites Beispiel eines Kontaktelementes.

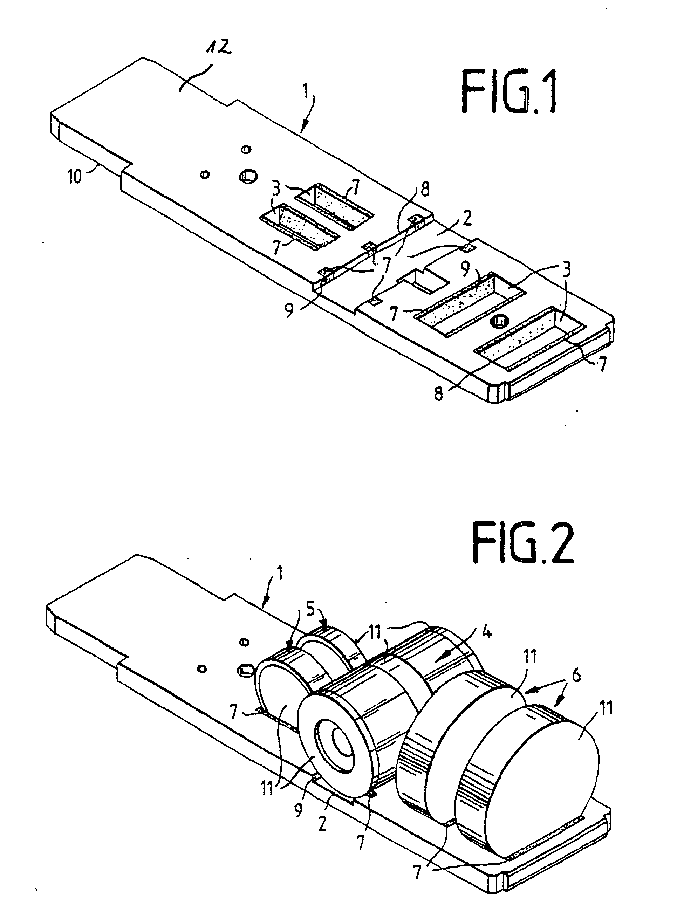

In der Fig. 1 ist eine erfindungsgemäß ausgebildete Leiterplatte 1 dargestellt, die über verschiedene Bereiche verfügt, die in das Material der Leiterplatte 1 eingearbeitet sind. Dabei ist einmal eine Nut 2 in die Oberfläche 12 der Leiterplatte 1 eingearbeitet, die zur Aufnahme eines in dieser Figur nicht dargestellten Überspannungsableiters vorgesehen ist. Die verwendete Leiterplatte 1 hat dabei im Gegensatz zu bisher verwendeten Leiterplatten mit einer Dicke von 0,8 mm eine Gesamtstärke von 1,2 mm, so dass in die Leiterplatte 1 eine Nut 2 mit einer ausreichenden Tiefe eingearbeitet werden kann. Die Breite der Nut 2 sollte unter Berücksichtigung ihrer Tiefe und der äußeren Abmessungen des Überspannungsableiters gewählt werden, so dass der eingesetzte Überspannungsableiter allein durch die Form der Nut 2 in der gewünschten Position gehalten und auch bei der Bewegung durch einen Durchlaufofen ein Verschieben oder Verrücken vermieden wird.

Zusätzlich zur Nut 2 sind Schlitzkonturen 3 in die Oberfläche der Leiterplatte 1 eingearbeitet, in denen andere elektronische Bauelemente, die bei dieser Darstellung ebenfalls nicht erkennbar sind, aufgenommen werden können.

Die eingearbeiteten Bereiche (Nut 2, Schlitzkonturen 3) können beispielsweise durch Fräsen oder Stanzen beim Herstellen der Leiterplatte 1 ausgebildet werden.

Die Schlitzkonturen 3 sind bevorzugt nur an den Innenflächen 9 metallisiert, die mit Anschlussflächen 7 elektrisch versehen sind, wobei beispielsweise Kupfer galvanisch abgeschieden werden kann.

Nachdem Lötpaste an den entsprechenden Stellen im Bereich der eingearbeiteten Strukturen durch geeignete Verfahren aufgetragen worden ist, kann die Bestückung mit den verschiedenen elektronischen Bauelementen in automatisierter Form und einem Arbeitsgang durchgeführt werden.

Die in der Fig. 2 dargestellte Leiterplatte 1 ist mit einem Überspannungsableiter 4, der in die Nut 2 eingesetzt ist, und zwei Varistoren 5 sowie zwei PTCs 6, die in Schlitzkonturen 3 eingesetzt sind, bestückt. Dabei ist erkennbar, dass die verwendeten Bauelemente in ihren Abmessungen mit den als Nut 2 bzw. Schlitzkonturen 3 ausgebildeten Bereichen in ihrer Dimensionierung so aufeinander abgestimmt sind, dass allein die Form der Bereiche ein Verschieben verhindert und die elektronischen Bauelemente in der gewünschten Position lagegenau gehalten werden. Werden zumindest einzelne der Flächen, die die eingearbeiteten Bereiche einfassen, abgeschrägt, wirkt sich dieses beim Vorgang der Bestückung der Leiterplatte 1 positiv aus, da das Einfädeln der Bauelemente erleichtert wird.

Die gemäß Fig. 2 bestückte Leiterplatte 1 kann nun einem Reflow-Lötprozess zugeführt werden, um eine stabile Verbindung der Bauelemente mit der Leiterplatte 1 herzustellen, und es kann auch während der hierfür erforderlichen Bewegung der bestückten Leiterplatte 1 ein Verschieben der Bauelemente verhindert werden.

Als elektronische Bauelemente (PTCs 6, Varistoren 5) können kostengünstige Bauelemente in Chipform verwendet werden, die zumindest über eine lötbare Oberfläche 11 verfügen, wobei die Kontaktierung der jeweiligen Bauelemente innerhalb der Leiterplatte 1 über eine für diese Elemente zu verwendende Schlitzkontur 3 ausgeführt wird. Die Lageorientierung der Bauelemente soll günstigerweise senkrecht zur Leiterplatte bei der Bestückung erfolgen, wobei die eigentliche Lötverbindung über die Stirnseiten der jeweiligen Bauelemente hin zu den Anschlussflächen 7 (PADs), die neben der Schlitzkontur 3 oder der Nut 2 angeordnet sind, erfolgt.

Die in die Leiterplatte 1 eingearbeiteten Nuten 2 und Schlitzkonturen 3 erhöhen zusätzlich die Festigkeit der mit dem Lötprozess hergestellten Verbindung, da durch die Anpassung der jeweiligen Konturen unter Berücksichtigung der Außenkonturen des jeweils verwendeten Bauelementes auch die verwendete Form einen Einfluss auf die letztendlich erreichbare Festigkeit der Verbindung hat.

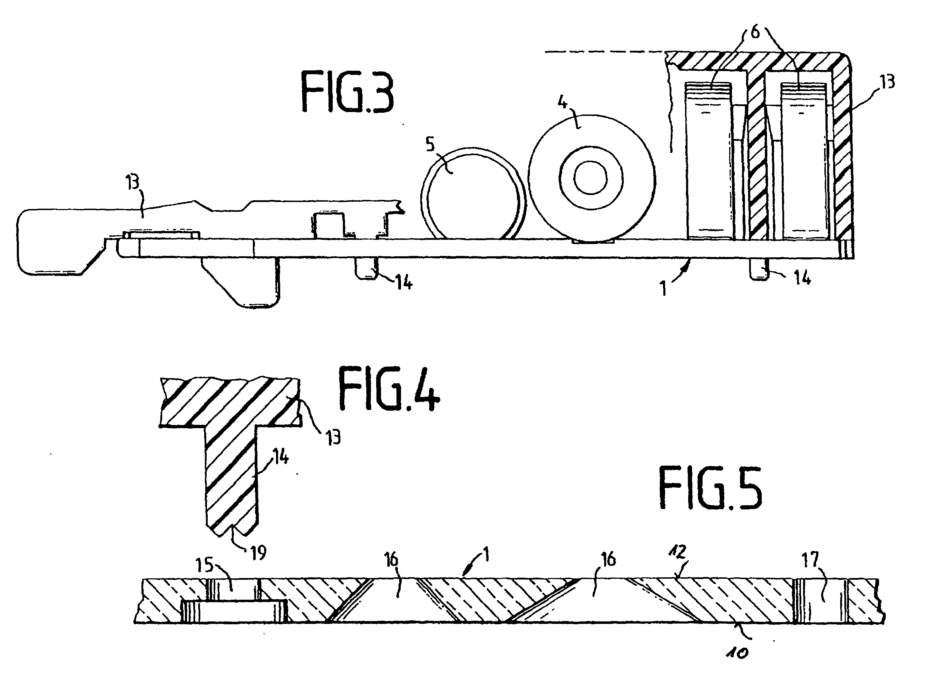

Die Fig. 3 zeigt ein Modul, bei dem auf eine als Leiterplatte 1 ausgebildete Grundplatte, die bereits mit diversen elektronischen Bauelementen, wie beispielsweise einem Überspannungsableiter 4, Varistor 5 und PTCs 6 bestückt ist, das Gehäuse 13 aufgesetzt ist. Dabei durchgreifen domartig ausgebildete Ansätze 14 die Leiterplatte 1 in durch diese hindurchgehende Ausnehmungen 15, 16 oder 17, so dass die Ausnehmungen 15, 16 oder 17 mit Ansatzmaterial zumindest teilweise ausgefüllt sind. Bei dem in Fig. 3 dargestellten Beispiel überragen die domartig ausgebildeten Ansätze 14 die Leiterplatte 1 über deren Unterseite 10 hinaus. In manchen Fällen ist es jedoch nicht erforderlich, dass die Ansätze 14 so groß dimensioniert sind, sondern können auch kleiner ausgebildet werden.

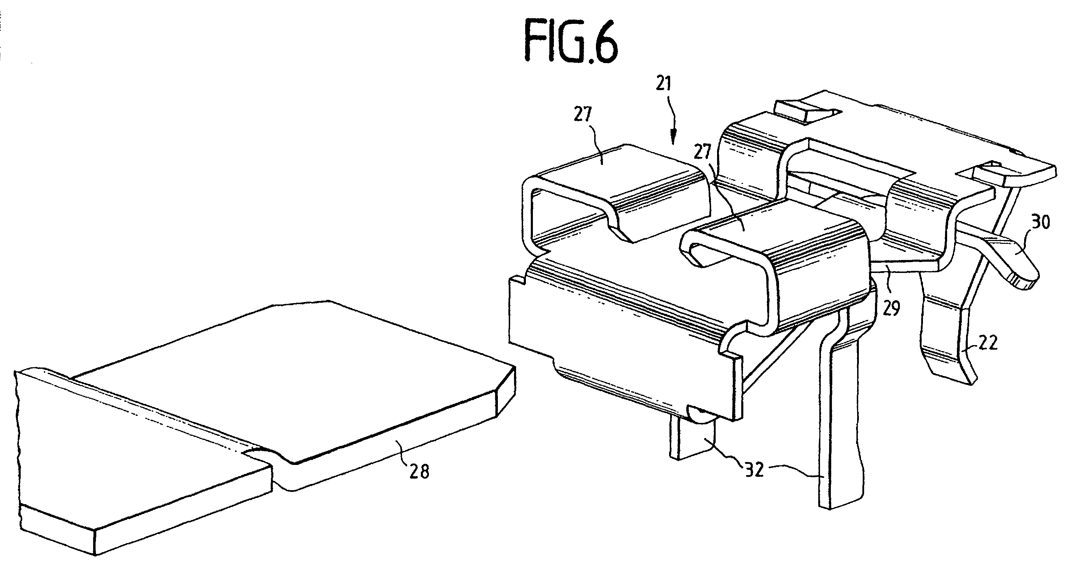

In einer bevorzugten Ausführungsform sind die Ansätze 14, die im Gehäuse 13 vorhanden sind, wie dies in der Fig. 4 dargestellt ist, zylinderförmig oder eckig ausgebildet und haben an ihrer Stirnfläche eine Einbuchtung oder Einkerbung 19, die geeignet ist, einen nicht dargestellten Dorn bei der Heißprägung, das heißt bei Erwärmung und gleichzeitigem Druck auf den Ansatz 14 zu halten und das Ansatzmaterial beim durch Druck- und Temperaturerhöhung auftretenden Fließen besser in die gewünschte Form zu bringen und ein Verrutschen zu verhindern.

Der Fig. 5 sind mögliche Formen für Ausnehmungen 15 - 17, die in die Leiterplatte 1 eingearbeitet werden können, zu entnehmen. Dabei sind in der Fig. 5 in der äußersten linken Darstellung die Ausbildung eines Sackloches, in den beiden Darstellungen von Ausnehmungen 16 in der Mitte der Fig. 5 die Ausbildung von Senken mit sich in Richtung auf die Oberseite 12 der Leiterplatte 1 verjüngenden Querschnitten und in der äußersten rechten Darstellung eine Bohrung oder eine eckig im Querschnitt ausgebildete Durchbrechung erkennbar.

Die Ausnehmungen 15, 16, die wie ein Sackloch oder als Senke ausgebildet sind, haben gegenüber der dritten gezeigten Möglichkeit den Vorteil, dass die letztendlich hergestellte Verbindung einen höheren Formschlussanteil hat und demzufolge sicherer ist.

Werden dagegen die Ausnehmungen 17 als Bohrung oder mit rechteckigem Querschnitt ausgebildete Durchbrechung ausgeführt, sind zwar die erzielbaren Verbindungskräfte geringer, ein späteres eventuell erforderliches Trennen der Verbindung kann bei einer solchen Variante jedoch wesentlich einfacher und zerstörungsfrei erfolgen.

Das in Fig. 6 gezeigte Kontaktelement 21 verfügt über einen federnden ersten Kontaktbügel 22, der in Richtung auf eine in dieser Darstellung nicht erkennbare Mittelelektrode 23 eines Überspannungsableiters 4 abgewinkelt ist. Dabei berührt der Kontaktbügel 22 die Mittelelektrode 23, die im Überspannungsfall innerhalb des Überspannungsableiters 4 mit dessen Außenelektroden 25 und 26 verbunden wird. Die Außenelektroden 25 und 26 ihrerseits sind im eingesteckten Zustand des Schutzsteckers mit jeweils einer Fernmeldeader verbunden. Das Kontaktelement 21 weist eine Steckaufnahme in Form von zwei umgebogenen federnden Laschen 27 auf, in die eine mit einer Erdschiene verbundene Kontaktfahne 28 eingesteckt ist. Somit wird im Falle einer Überspannung eine Erdverbindung von den Fernmeldeadern a bzw. b über die Außenelektrode 25 bzw. 26, den Überspannungsableiter 4, die Mittelelektrode 23, den Kontaktbügel 22 und die Laschen 27 des Kontaktelementes 21 sowie die Kontaktfahne 28 zur Erdschiene hergestellt.

Das einstückige Kontaktelement 21 weist einen zweiten federnden Kontaktbügel 29 auf, der an seinem freien Ende in einen Quersteg 30 übergeht. Die beiden Enden des Quersteges 30 liegen den Außenelektroden 25 bzw. 26 des Überspannungsableiters 4 gegenüber. Zwischen den Enden des Quersteges 30 ist auf der dem Überspannungsableiter 4 zugewandten Seite des Kontaktbügels 29 eine Lotpille 31 befestigt, die unter der Federkraft des Kontaktbügels 29 an der isolierenden Außenfläche oder der Mittelelektrode 23 des Überspannungsableiters 4 anliegt und hierdurch die Enden des Quersteges 30 des Kontaktbügels 29 im Abstand von den Außenelektroden 25 bzw. 26 hält. Bei einer übermäßigen Erwärmung des Überspannungsableiters 4, die beispielsweise auftreten kann, wenn über eine längere Zeit eine erhöhte Spannung zwischen den Fernmeldeadern a, b liegt, die jedoch noch nicht zum Ansprechen des Überspannungsableiters 4 führt, schmilzt die Lotpille 31. Diese kann somit nicht mehr verhindern, dass sich der Quersteg 30 durch die Federkraft des Kontaktbügels 29 an die Außenelektroden 25 und 26 des Überspannungsableiters 4 anlegt, so dass nunmehr eine Erdverbindung zwischen diesen und der Erdschiene über das Kontaktelement 21 mit dem Quersteg 30, dem Kontaktbügel 29 und den Laschen 27 sowie die Kontaktfahne 28 besteht.

In Fig. 6 sind weiterhin zwei Haltebeine 32 des Kontaktelements 21 in bezug auf den Kontaktbügel 22 auf der anderen Seite des Überspannungsableiters 4 angeordnet, so dass sie als Widerlager dienen und eine einseitige Belastung der Lötverbindung zwischen dem Überspannungsableiter 4 und der diesen tragenden Leiterplatte verhindern.

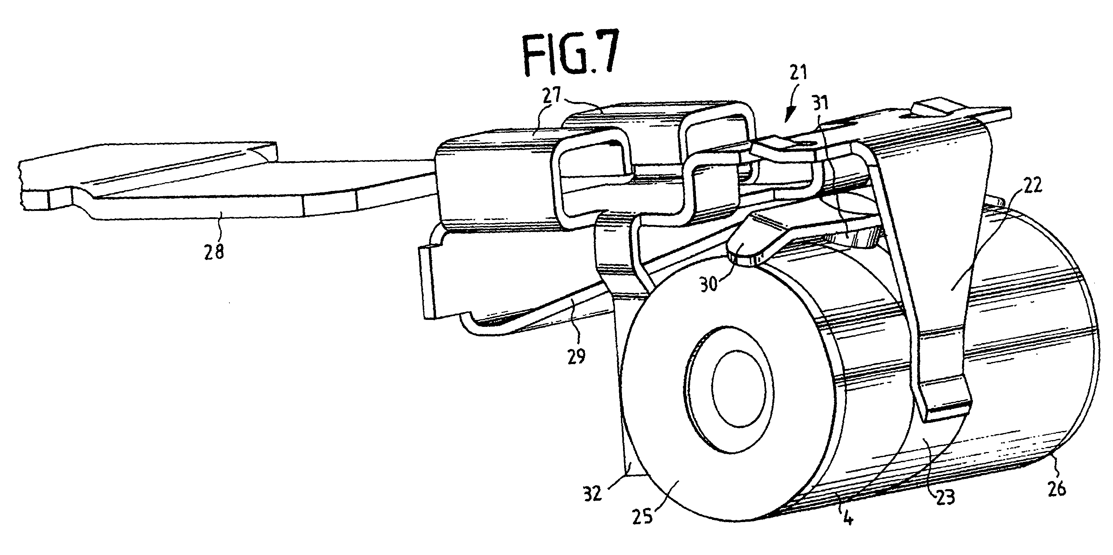

In Fig. 7 ist das Kontaktelement nach Fig. 6 auf den Überspannungsableiter 4 aufgesetzt dargestellt und es ist außerdem erkennbar, dass die Haltebeine 32 an der isolierten Außenfläche des Überspannungsableiters 4 zu beiden Seiten der Mittelelektrode 23 anliegen.

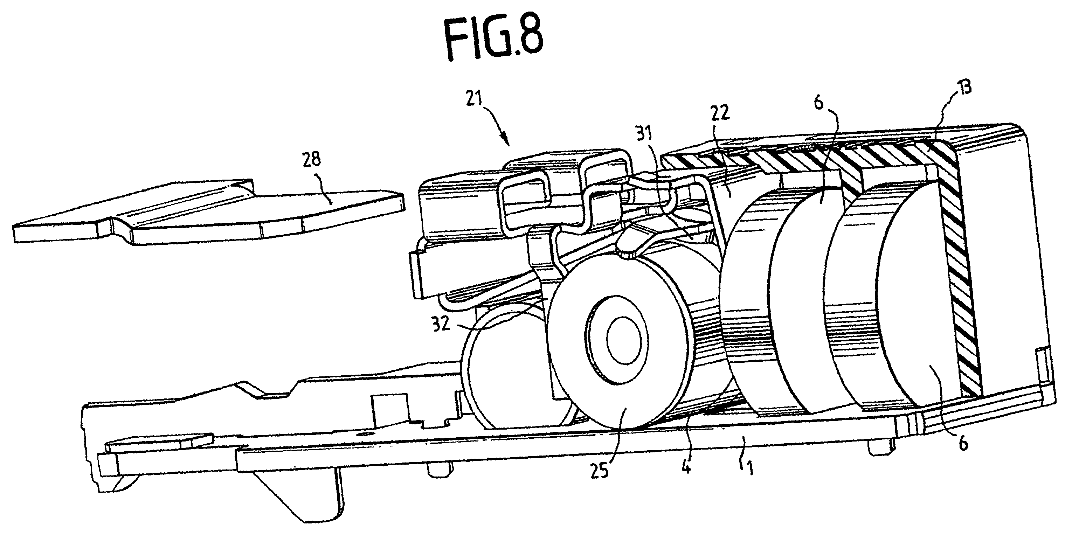

In Fig. 8 ist der Schutzstecker im eingesteckten Zustand dargestellt, wobei auf eine Leiterplatte 1 innerhalb eines Gehäuses 13 mehrere elektronische Bauelemente, wie beispielsweise PTCs 6, sowie der Überspannungsableiter 4 aufgesetzt sind. Das Kontaktelement 21 ist hierbei wie bereits in der Darstellung in Fig. 7 auf den Überspannungsableiter 4 aufgesetzt. Gleichzeitig wird es auch vom Gehäuse 13 gehalten.

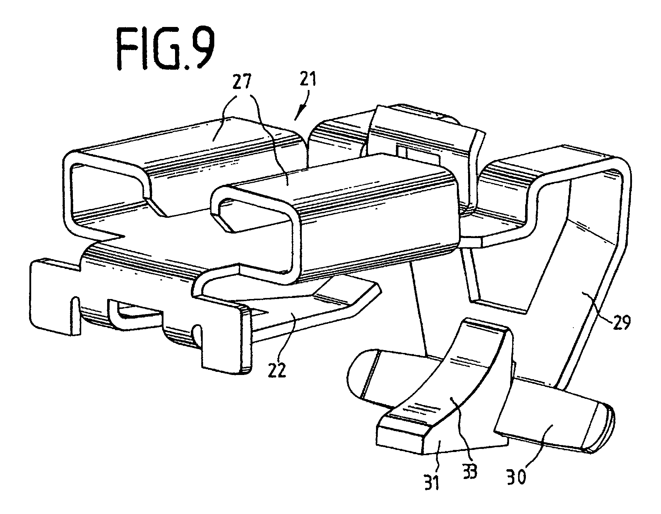

In Fig. 9 ist eine andere Ausführungsform eines Kontaktelementes 21 dargestellt. Der zweite Kontaktbügel 29 liegt dem ersten Kontaktbügel 22 so gegenüber und die Lotpille 31 ist dem Außenumfang des Überspannungsableiters 4 so angepasst, dass diese das Widerlager zum Kontaktbügel 22 bildet und daher die Haltebeine 12 nicht erforderlich sind. Die Lotpille 31 hat eine innere Anlagefläche 33 in Form eines Kreisbogenabschnitts, dessen Radius gleich dem Radius des zylindrischen Überspannungsableiters 4 ist. In den mittleren Abschnitt des Quersteges 30 ist eine Ausnehmung eingearbeitet, in die die Lotpille 31 einsetzbar und in dieser einrastbar ist.

### Bezugszeichenliste

- 1: Leiterplatte
- 2: Nut
- 3: Schlitzkontur
- 4: Überspannungsableiter
- 5: Varistoren
- 6: PTCs
- 7: Anschlussflächen
- 8: Ränder
- 9: Innenflächen
- 10: Unterseite
- 11: Oberfläche
- 12: Oberfläche
- 13: Gehäuse
- 14: Ansätze
- 15, 16: und 17 Ausnehmungen
- 19: Einkerbungen
- 21: Kontaktelement
- 22: Kontaktbügel
- 23: Mittelelektrode
- 25, 26: Außenelektroden
- 27: Laschen
- 28: Kontaktfahne
- 29: Kontaktbügel
- 30: Quersteg
- 31: Thermoelement
- 32: Haltebeine
- 33: Innere Anlagefläche

## Patentansprüche

1. Leiterplatte (1) zur lagegenauen Bestückung mit elektronischen Bauelementen, die auf der Oberfläche (12) der Leiterplatte (1) angelötet werden, wobei in der Oberfläche (12) der Leiterplatte (1) der Außenkontur der jeweiligen Bauelemente zumindest teilweise angepasste Bereiche zur Aufnahme der elektronischen Bauelemente eingearbeitet sind, wobei die Innenflächen (9) der angepassten Bereiche zumindest teilweise randmetallisiert sind, und wobei die eingearbeiteten Bereiche als Schlitzkontur (3) ausgebildet sind,
**dadurch gekennzeichnet, dass**
die Innenflächen (9) der eingearbeiteten Bereiche an den Längsflächen randmetallisiert sind, wobei auf der Unterseite (10) der Leiterplatte (1) eine isolierende Abdeckung aufgebracht ist.

2. Leiterplatte nach Anspruch 1, **dadurch gekennzeichnet, dass** mindestens ein eingearbeiteter Bereich in Form einer Nut (2) ausgebildet ist.

3. Leiterplatte nach Anspruch 1 oder 2, **dadurch gekennzeichnet, dass** neben den eingearbeiteten Bereichen Anschlüsse oder Anschlussflächen (7) angeordnet sind.

4. Leiterplatte nach Anspruch 3, **dadurch gekennzeichnet, dass** die Anschlüsse oder Anschlussflächen (7) an den Rändern (8) der eingearbeiteten Bereiche angeordnet sind.

5. Leiterplatte nach einem der Ansprüche 1 bis 4, **dadurch gekennzeichnet, dass** ein Gehäuse (13) zur Abdeckung der Leiterplatte (1) domartig ausgebildete Ansätze (14) aus einem zumindest teilweise verformbaren Material in Richtung auf die zu verbindende Leiterplatte (1) aufweist, die in die Leiterplatte (1), diese durchdringend, eingearbeitete Ausnehmungen (15 - 17) eingreifen, wobei die in ihrer Größe, die Form und Größe der Ausnehmungen berücksichtigend, so dimensioniert sind, dass eine form- und/oder kraftschlüssige Gehäuse-Leiterplatten-Verbindung durch Verformung der Ansätze (14) unter Einwirkung von Energie und/oder Kraft entsteht, derart, dass die domartigen Ansätze (14) bei hergestellter Gehäuse-Leiterplatten Verbindung nicht über die Unterseite (10) der Leiterplatte (1) hinausragen.

6. Leiterplatte nach Anspruch 5, **dadurch gekennzeichnet, dass** die Ausnehmungen (15) als Sackloch ausgebildet sind.

7. Leiterplatte nach Anspruch 5 oder 6, **dadurch gekennzeichnet, dass** die Ausnehmungen (16) sich von der Unterseite (10) der Leiterplatte (1) zur Oberfläche (12) der Leiterplatte (1) hin verjüngende Senken sind.

8. Leiterplatte nach einem der Ansprüche 5 bis 7, **dadurch gekennzeichnet, dass** die Ausnehmungen (17) als über die gesamte Stärke der Leiterplatte (1) gleichförmig ausgebildete Bohrungen oder mit einem eckigen Querschnitt ausgebildete Durchbrechungen ausgebildet sind.

9. Leiterplatte nach einem der Ansprüche 5 bis 8, **dadurch gekennzeichnet, dass** die domartigen Ansätze (14) aus einem thermoplastischen Material gebildet sind.

10. Leiterplatte nach einem der Ansprüche 5 bis 9, **dadurch gekennzeichnet, dass** die Ansätze (14) an ihrer Richtung auf die Unterseite (10) der Leiterplatte (1) weisenden Stirnfläche eine Vertiefung oder Einkerbung (19) aufweisen.

11. Leiterplatte nach Anspruch 1 oder 5, **dadurch gekennzeichnet, dass** ein Überspannungs-Schutzstecker für Anschlussleisten der Fernmeldetechnik aus einem steckbaren Isolierstoffgehäuse mit einem Überspannungsableiter (4) mit zwei jeweils mit einer Fernmeldeader verbundenen Außenelektroden (25, 26) und einer mit der Erdschiene verbundenen Mittelelektrode (23) und mit einem thermischen Überlastschutz, durch den bei einer übermäßigen Erwärmung des Überspannungsableiters (4) die Fernmeldeadern mit der Erdschiene verbunden werden, aufgesetzt ist, wobei ein in das Gehäuse einsteckbares einteiliges Kontaktelement (21) vorgesehen ist, dass einen im eingesteckten Zustand mit der Mittelelektrode (23) des montierten Überspannungsableiters (4) in Berührung stehenden ersten Kontaktbügel (22), eine Steckaufnahme für eine mit der Erdschiene fest verbundene Kontaktfahne (28) und einen federnden zweiten Kontaktbügel (29), der durch ein Thermoelement (31) im Abstand von den Außenelektroden (25,26) gehalten ist und bei übermäßiger Erwärmung durch eine Formänderung des Thermoelementes (31) aufgrund seiner federnden Eigenschaft in Anlage an beide Außenelektroden (25,26) bringbar ist, aufweist.

12. Leiterplatte nach Anspruch 11, **dadurch gekennzeichnet, dass** der zweite Kontaktbügel (29) an seinem freien Ende in einen Quersteg (30) übergeht, dessen Enden jeweils mit einer der Außenelektroden (25,26) in Kontakt bringbar sind und zwischen dessen Enden sich das Thermoelement (31) befindet.

13. Leiterplatte nach Anspruch 11 oder 12, **dadurch gekennzeichnet, dass** das Thermoelement (31) ein bei Erwärmung schmelzendes Formteil oder ein Bimetall ist, aus einem bei Erwärmung erweichenden Material oder aus einer Memorylegierung gebildet ist.

14. Leiterplatte nach einem der Ansprüche 11 bis 13, **dadurch gekennzeichnet, dass** das Thermoelement (31) fest mit dem zweiten Kontaktbügel (29) verbunden ist.

15. Leiterplatte nach einem der Ansprüche 11 bis 14, **dadurch gekennzeichnet, dass** das Thermoelement (31) in dem zweiten Kontaktbügel(29) eingerastet ist.

16. Leiterplatte nach einem der Ansprüche 11 bis 15, **dadurch gekennzeichnet, dass** das Kontaktelement (21) auf der dem ersten Haltebügel (22) gegenüberliegenden Seite des Überspannungsableiters (4) mindestens ein an dessen isolierender Oberfläche federnd anliegendes Haltebein (32) aufweist.

## Claims

1. Printed circuit board (1) for fitting electronic components, which are soldered on the surface (12) of the printed circuit board (1), accurately in position, with areas which are at least partially matched to the external contour of the respective components being incorporated in the surface (12) of the printed circuit board (1) in order to accommodate the electronic components, with the inner surfaces (9) of the matched areas being at least partially edge-metallized, and with the incorporated areas being in the form of a slot structure (3),
**characterized in that**
the inner surfaces (9) of the incorporated areas are edge-metallized on the longitudinal surfaces, with an insulating cover being applied to the lower face (10) of the printed circuit board (1).

2. Printed circuit board according to Claim 1, **characterized in that** at least one incorporated area is in the form of a groove (2).

3. Printed circuit board according to Claim 1 or 2, **characterized in that** connections or pads (7) are arranged alongside the incorporated areas.

4. Printed circuit board according to Claim 3, **characterized in that** the connections or pads (7) are arranged on the edges (8) of the incorporated areas.

5. Printed circuit board according to one of Claims 1 to 4, **characterized in that** a housing (13) for covering the printed circuit board (1) has attachments (14) which are in the form of domes and are composed of a material which can at least partially be deformed in the direction of the printed circuit board (1) to be connected, which attachments (14) engage in recesses (15 - 17), which are incorporated in the printed circuit board (1) and pass through it, whose sizes, taking account of the shape and size of the recesses, are dimensioned such that an interlocking and/or force-fitting connection is produced between the housing and the printed circuit board by deformation of the attachments (14) under the influence of energy and/or force, such that the dome-like attachments (14) do not project beyond the lower face (10) of the printed circuit board (1) once the connection between the housing and the printed circuit board has been produced.

6. Printed circuit board according to Claim 5, **characterized in that** the recesses (15) are in the form of blind holes.

7. Printed circuit board according to Claim 5 or 6, **characterized in that** the recesses (16) are indentations which taper from the lower face (10) of the printed circuit board (1) towards the surface (12) of the printed circuit board (1).

8. Printed circuit board according to one of Claims 5 to 7, **characterized in that** the recesses (17) are in the form of bores, which are formed uniformly over the entire thickness of the printed circuit board (1), or are in the form of apertures which are formed with a polygonal cross section.

9. Printed circuit board according to one of Claims 5 to 8, **characterized in that** the dome-like attachments (14) are formed from a thermoplastic material.

10. Printed circuit board according to one of Claims 5 to 9, **characterized in that** the attachments have a depression or notch (19) on their end surface pointing in the direction of the lower face (10) of the printed circuit board (1).

11. Printed circuit board according to Claim 1 or 5, **characterized in that** an overvoltage protective plug for connecting strips for telecommunications technology and composed of a plug-in insulating material housing with an surge arrester (4), with two outer electrodes (25, 26), which are each connected to a telecommunications conductor, and with a centre electrode (23) which is connected to the earth rail, and with thermal overload protection, by means of which the telecommunications conductors are connected to the earth rail if the surge arrester (4) is heated excessively, is fitted, with an integral contact element (21), which can be inserted into the housing, being provided, which has a first contact clip (22) (which, in the inserted state, makes contact with the centre electrode (23) of the surge arrester (4) which is fitted), a plug holder for a contact lug (28) which is firmly connected to the earth rail, and a sprung second contact clip (29), which is held at a distance from the outer electrode (25, 26) by a thermal element (31) and can be brought into contact with the two outer electrodes (25, 26) by means of a shape change of the thermal element (31) and by virtue of its sprung characteristic, when excessively heated.

12. Printed circuit board according to Claim 11, **characterized in that** the second contact clip (29) merges at its free end into a transverse web (30), whose ends can each be brought into contact with one of the outer electrodes (25, 26), and between whose ends the thermal element (31) is located.

13. Printed circuit board according to Claim 11 or 12, **characterized in that** the thermal element (31) is a moulding which melts when heated or is a bimetallic element, and is formed from a material which softens when it is heated, or is formed from a memory alloy.

14. Printed circuit board according to one of Claims 11 to 13, **characterized in that** the thermal element (31) is firmly connected to the second contact clip (29).

15. Printed circuit board according to one of Claims 11 to 14, **characterized in that** the thermal element (31) is latched in the second contact clip (29).

16. Printed circuit board according to one of Claims 11 to 15, **characterized in that** the contact element (21) has at least one holding leg (32), which rests in a. sprung manner on its insulating surface, on the side of the surge arrester (4) which is opposite the first holding clip (22).

## Revendications

1. Plaquette de circuits imprimés (1) pour montage en positions précises de composants électroniques qui sont brasés sur la surface supérieure (12) de la plaquette de circuits imprimés (1), dans laquelle des zones au moins en partie adaptées au contour externe des composants respectifs sont ménagées dans la surface supérieure (12) de la plaquette de circuits imprimés (1) pour recevoir les composants électriques, les surfaces internes (9) des zones adaptées sont au moins en partie métallisées sur les bords et les zones ménagées se présentent sous la forme d'un contour en fente (3), **caractérisée en ce que** les surfaces internes (9) des zones ménagées sur les surfaces longitudinales sont métallisées sur les bords, un revêtement isolant étant appliqué sur la face inférieure (10) de la plaquette de circuits imprimés (1).

2. Plaquette de circuits imprimés selon la revendication 1, **caractérisée en ce qu'**au moins une zone ménagée se présente sous la forme d'une rainure (2).

3. Plaquette de circuits imprimés selon la revendication 1 ou 2, **caractérisée en ce que** des connexions ou des surfaces de connexion (7) sont aménagées à côté des zones ménagées.

4. Plaquette de circuits imprimés selon la revendication 3, **caractérisée en ce que** les connexions ou les surfaces de connexion (7) sont aménagées sur les bords (8) des zones ménagées.

5. Plaquette de circuits imprimés selon les revendications 1 à 4, **caractérisée en ce qu'**un boîtier (13) pour recouvrir la plaquette de circuits imprimés (1) présente des saillies (14) en forme de dôme constituées d'un matériau au moins en partie déformable dans la direction de la plaquette de circuits imprimés (1) à connecter, lesdites saillies (14) s'engageant dans des évidements (15-17) ménagés dans la plaquette de circuits imprimés (1) et traversant celle-ci, lesdites saillies ayant des dimensions qui sont fonction de la forme et des dimensions des évidements de sorte qu'il se forme une liaison mécanique et/ou géométrique boîtier-plaquette de circuits imprimés par déformation des saillies (14) sous l'influence d'énergie et/ou d'une force de manière que les saillies (14) en forme de dôme ne dépassent pas de la face inférieure (10) de la plaquette de circuits imprimés (1) dans l'assemblage fabriqué boîtier-plaquette de circuits imprimés.

6. Plaquette de circuits imprimés selon la revendication 5, **caractérisée en ce que** les évidements (15) se présentent sous la forme de trous borgnes.

7. Plaquette de circuits imprimés selon la revendication 5 ou 6, **caractérisée en ce que** les évidements (16) sont des puits se rétrécissant depuis la face inférieure (10) de la plaquette de circuits imprimés (1) vers la surface supérieure (12) de la plaquette de circuits imprimés (1).

8. Plaquette de circuits imprimés selon l'une quelconque des revendications 5 à 7, **caractérisée en ce que** les évidements (17) se présentent sous la forme d'orifices conformés de manière uniforme sur toute l'épaisseur de la plaquette de circuits imprimés (1) ou d'ouvertures conformées avec une section transversale polygonale.

9. Plaquette de circuits imprimés selon l'une quelconque des revendications 5 à 8, **caractérisée en ce que** les saillies (14) en forme de dôme sont constituées d'un matériau thermoplastique.

10. Plaquette de circuits imprimés selon l'une quelconque des revendications 5 à 9, **caractérisée en ce que** les saillies (14) présentent un renfoncement ou une encoche (19) sur leur face avant montrant la direction de la surface inférieure (10) de la plaquette de circuits imprimés (1).

11. Plaquette de circuits imprimés selon la revendication 1 ou 5, **caractérisée en ce qu'**on y dépose un connecteur de protection contre la surtension pour réglettes de raccordement en technique de télécommunications, formé d'un boîtier de matériau isolant emboîtable avec une dérivation de surtension (4), comprenant deux électrodes externes (25, 26) connectées respectivement à un conducteur de télécommunications et une électrode centrale (23) connectée au collecteur de terre, et avec un élément de protection contre les surcharges thermiques, par lequel, lors d'un échauffement excessif de la dérivation de surtension (4), les conducteurs de télécommunications sont raccordés au collecteur de terre, un élément de contact (21) d'une seule pièce emboîtable dans le boîtier étant prévu, ledit élément de contact (21) présentant un premier étrier de contact (22), qui, à l'état emboîté, est en contact avec l'électrode centrale (23) de la dérivation de surtension montée (4), un logement récepteur pour un talon de contact (28) connecté de manière fixe au collecteur de terre et un second étrier de contact élastique (29), qui est maintenu à distance des électrodes externes (25,26) par un thermocouple (31) et peut, lors d'un échauffement excessif, être amené en appui sur les deux électrodes externes (25, 26) par modification de forme du thermocouple (31) en raison de sa propriété élastique.

12. Plaquette de circuits imprimés selon la revendication 11, **caractérisée en ce que** le second étrier de contact (29) se transforme, à son extrémité libre, en une âme transversale (30) dont les extrémités peuvent être amenées en contact avec une des électrodes externes (25, 26) et entre les extrémités de laquelle se trouve le thermocouple (31).

13. Plaquette de circuits imprimés selon la revendication 11 ou 12, **caractérisée en ce que** le thermocouple (31) est une pièce façonnée fondant par échauffement ou un bimétal qui est formé d'un matériau se ramollissant par échauffement ou d'un alliage à mémoire.

14. Plaquette de circuits imprimés selon l'une quelconque des revendications 11 à 13, **caractérisée en ce que** le thermocouple (31) est raccordé au second étrier de contact (29) de manière fixe.

15. Plaquette de circuits imprimés selon l'une quelconque des revendications 11 à 14, **caractérisée en ce que** le thermocouple (31) est encliqueté dans le second étrier de contact (29).

16. Plaquette de circuits imprimés selon l'une quelconque des revendications 11 à 15, **caractérisée en ce que** l'élément de contact (21) présente, sur le côté de la dérivation de surtension (4) opposé au premier étrier de maintien (22), au moins une jambe de maintien (32) s'appliquant de manière élastique sur sa surface isolante.
